# EUROPEAN PATENT APPLICATION

(11) **EP 4 199 082 A1**
(43) Date of publication of application: **21.06.2023**
(21) Application number: 21215208.6
(22) Date of filing: 16.12.2021
(51) Int. Cl.: H01L 23/66, H03F 3/19, H01L 21/66, H03F 3/195, H05K 1/02, H01L 27/085

(54) **POWER AMPLIFIER MODULE AND POWER AMPLIFIER COMPRISING THE SAME**

(71) Applicant: Ampleon Netherlands B.V., 6534 AV Nijmegen (NL)
(72) Inventor: BONTE DUPONT, Ariane, 6534 AV Nijmegen (NL)
(74) Representative: Arnold & Siedsma

(57) **Abstract**

The present invention relates to a power amplifier module. The present invention further relates to a power amplifier comprising such a power amplifier module.

The power amplifier comprises a power amplifier module mounted on a first printed circuit board. The power amplifier module comprises a second printed circuit board having a first module input/output pad, and a semiconductor die having at least one power transistor integrated thereon. The power amplifier module further comprises a decoupling capacitor that is mounted on the second printed circuit board. A first terminal thereof is electrically coupled to a first module input/output pad for receiving a biasing signal for the at least one power transistor.

According to the present invention, a second terminal of the decoupling capacitor is connected to a second module input/output pad of the power amplifier module that is electrically isolated from the first module input/output pad of the power amplifier module, said second module input/output pad being electrically grounded during operation of the power amplifier.

## Description

The present invention relates to a power amplifier module. The present invention further relates to a power amplifier comprising such a power amplifier module.

Power amplifier modules, PAMs, are known in the art. An example of a known PAM 200 is illustrated in figures 1-3. Here, figure 1 illustrates a schematic top view of known PAM 200 which is mounted on a first printed circuit board, PCB, 100. PAM 200 and PCB 100 are part of a power amplifier 1. Figure 2 illustrates a cross-sectional view illustrating the various layers of power amplifier 1, and figure 3 illustrates a corresponding electrical schematic.

PAM 200 comprises a second PCB 210 and a semiconductor die 220 that is wire-bonded to a first side of PCB 210. On this same side, a die pad 211 and a plurality of bondpads 212 are provided. On the opposing second side, PCB 210 comprises a module ground pad 213 and a plurality of module input/output pads 214. PAM 200 comprises a solidified molding compound 300 that encapsulates semiconductor die 220. Molding compound 300 partially defines and forms the outer shape of PAM 200.

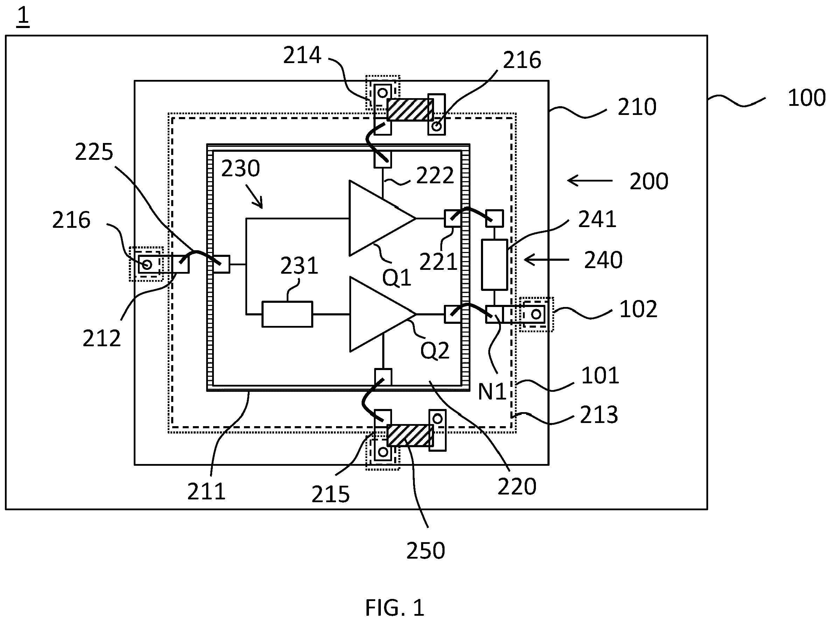

At least one power transistor Q1, Q2 is integrated on semiconductor die 220. Power transistors Q1, Q2 each comprise an input for receiving a signal to be amplified, a first output for outputting the amplified signal, and a second output. In figure 1, the first outputs of Q1 and Q2 are electrically connected to a respective module input/output pad 214. More in particular, each first output is connected to a die terminal 221 on semiconductor die 220 that in turn is connected to a bondpad 212 using a bondwire 225. Bondpad 212 is connected using a metal trace 215 and/or via 216 to a module input/output pad 214. Die terminals 221 are also used for connecting the inputs(s) of Q1 and Q2 and for connecting bias feed lines 222. These latter lines are used for providing a DC bias signal to the first outputs of Q1, Q2.

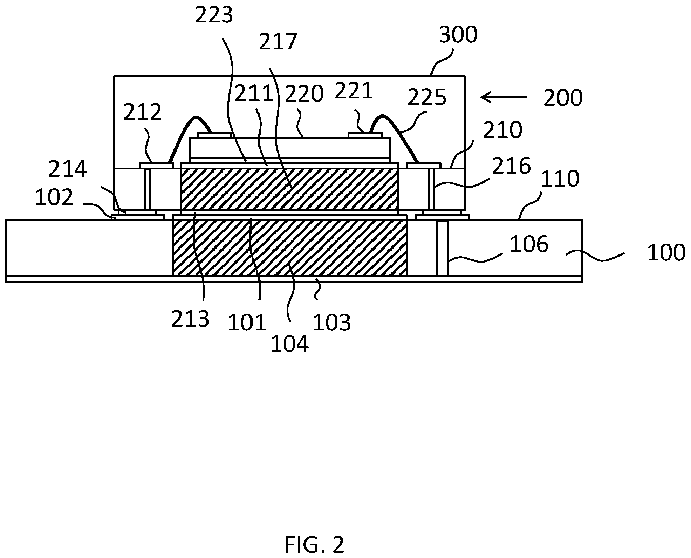

Semiconductor die 220 either has a conductive substrate or it is provided with a plurality of vias. On the backside, semiconductor die 220 is provided with a backside metallization 223, see figure 2. Backside metallization 223 is fixedly connected, using adhesive glue, solder, or the like, to die pad 211.

Figure 1 shows a PAM 200 in which a Doherty amplifier is realized. This amplifier comprises a main amplifier formed by transistor Q1 that is biased in class AB or B, and a peak amplifier formed by transistor Q2 that is biased in class C. PAM 200 comprises a Doherty splitter 230 for splitting a signal to be amplified into a signal component fed to main amplifier Q1, and into a signal component fed to peak amplifier Q2. Doherty splitter 230 may comprise a phase shifter 231.

PAM 200 comprises a Doherty combiner 240 for combining signals amplified by main amplifier Q1 and peak amplifier Q2. Doherty combiner 240 comprises an impedance inverter 241, typically realized using a quarter wavelength transmission line or an equivalent thereof. The phase offset imparted by phase shifter 231 is such that at combining node N1 the signals add up in phase.

In figure 1, Doherty combiner 240 is mostly realized on PCB 210 and Doherty splitter 230 on semiconductor die 220. However, other distributions of Doherty combiner 240 and Doherty splitter 230 are equally possible.

Die pad 211 is electrically connected to module ground pad 213. To this end, PCB 210 may be provided with a copper coin 217 or a plurality of vias.

PCB 100 comprises a board ground pad 101 and a plurality of board input/output pads 102, which are arranged on a top side 110 of PCB 100. Module input/output pads 214 are connected to the board input/output pads 102, and module ground pad 213 is connected to board ground pad 101 using adhesive glue, solder, or the like. On a backside of PCB 100, it is provided with a ground layer 103 that is configured to be electrically grounded during operation. As shown in figure 2, ground layer 103 can be connected to board ground pad 101 using a copper coin 104 or vias.

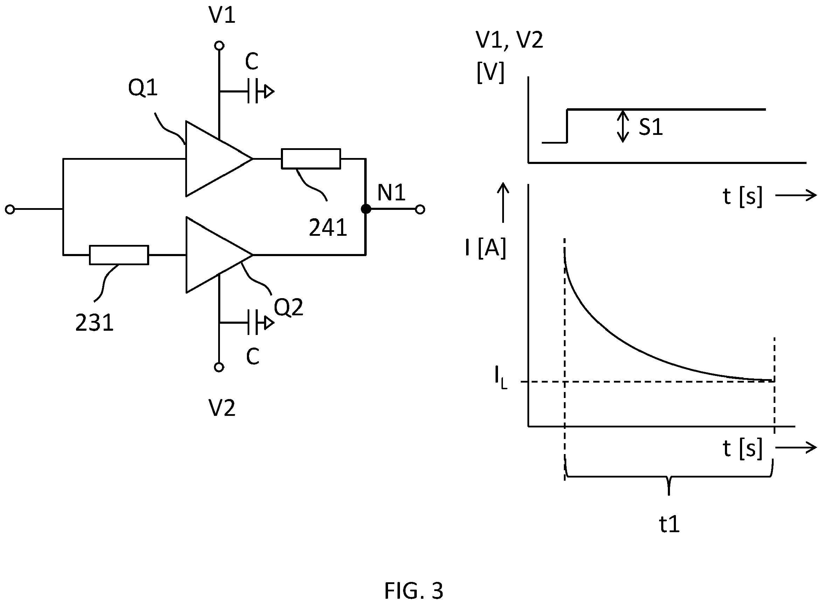

Although figures 1-3 illustrate a PAM 200 in which a Doherty amplifier is realized, it should be noted that PAMs are also known in which a single or multi-stage power amplifier is realized. Furthermore, figure 3 illustrates a Doherty amplifier having a regular configuration. Alternative configurations, such as an inverted Doherty amplifier or a parallel Doherty amplifier are equally known. The present invention also relates to all of these different PAMs.

Typically, PAM 200 is manufactured by a company different from the company that arranges PAM 200 on PCB 100. Being relatively costly components, PAM 200 is subjected to various electrical testing schemes to ensure that PAM 200 meets predefined criteria. One of those tests comprises determining the leakage current from the first output to the second output of power transistor Q1, Q2 with the input being at a predefined level, such as below the threshold voltage. This measurement comprises measuring the leakage current I_{L} a predetermined time t1 after applying a voltage step S1 is applied at module input/output pad 214. An example of such measurement is illustrated in figure 3, right hand side.

Figure 1 illustrates bias feed lines 222 for providing a DC bias signal to the first outputs of power transistors Q1 and Q2. Similar bias feed lines (not shown) can be arranged for providing a DC bias signal to the inputs of Q1 and Q2. These bias feed lines are connected to a different module input/output pad (not shown). Similar leakage tests as described above in conjunction with the first outputs of Q1 and Q2 can be performed to determine the leakage current from the input to the second output of power transistors Q1, Q2 with the first outputs being at a predefined level. For these measurements, a voltage step is applied at the abovementioned different module input/output pad.

To improve the video bandwidth and linearizability of PAM 200 it is important to provide appropriate decoupling at the point where DC supply voltages are provided to power transistQ1, Q2. In figure 1, these points correspond to bias feed lines 222. Hereinafter, module input/output pads 214 that are connected to bias feed lines 222 will be referred to as first module input/output pads 214.

Decoupling is typically realized using capacitors. An example thereof is shown in figure 3 where it is noted that in most applications, a large inductance (not shown) is connected in between the first, non-grounded terminal, of decoupling capacitor C, and the actual bias source VI, V2. Such large inductance may correspond to a quarter wavelength at the operational frequency.

The required capacitance values for the decoupling capacitors are relatively large. For this reason, decoupling capacitors C are typically realized using surface mount devices 250, SMDs, arranged on PCB 200 in between bondpad 212 or first module input/output pad 214 and module ground pad 213. More in particular, as shown in figure 1, a first terminal of SMD 250 is electrically connected to first module input/output pad 214, and a second terminal of SMD 250 is connected to module ground pad 213, for example using one or more vias 216 in PCB 210. Similarly, a SMD decoupling capacitor is typically also provided for decoupling the bias feed lines (not shown) that provide a DC bias signal to the inputs of Q1 and Q2.

As stated above, to improve the effectiveness of the decoupling offered by SMDs 250, it is preferred to use relatively high capacitance values. However, a drawback of capacitors having these capacitance values is that these capacitors have significant leakage current. More in particular, the leakage current through these capacitors is in the same order of magnitude as the leakage current through power transistors Q1, Q2 during the abovementioned measurement. In addition, there is considerable variation in leakage current between the decoupling capacitors. Consequently, if capacitors are used with relatively high capacitance values, it is no longer possible to efficiently measure the leakage of power transistors Q1, Q2. This will have an adverse effect on the yield of PAMs 200. For example, PAMs 200 may be approved that would otherwise, i.e. with capacitors having low capacitance values, be rejected due to excessive leakage current.

It is an object of the present invention, to provide a PAM and a power amplifier comprising the same, in which decoupling capacitors with relatively high capacitance values can be used while at the same time allowing appropriate testing to be conducted of the PAM.

According to a first aspect of the present invention, the abovementioned object has been achieved with the power amplifier according to claim 1, which is characterized in that the second terminal of the decoupling capacitor is connected to a second module input/output pad of the power amplifier module that is electrically isolated from the first module input/output pad of the power amplifier module, said second module input/output pad being electrically connected to the ground layer.

By using a separate module input/output pad for connecting the second terminal of the decoupling capacitor to ground, outside of PAM 200, it becomes possible to conduct effective testing of PAM 200 after manufacturing thereof. For example, during leakage current testing as described above, the module input/output pad that is connected to the second terminal of the decoupling capacitor can be left electrically floating. In that case, the decoupling capacitor will not influence the measurement of the leakage current through the power transistor. However, during operation, i.e. when PAM 200 is mounted on PCB 100, the second terminal of the decoupling capacitor is electrically connected to ground, thereby improving the video bandwidth behavior.

The first printed circuit board may comprise a first side and a second side opposite to the first side, wherein the first printed circuit board comprises a board ground pad and a plurality of board input/output pads arranged on the first side, wherein the board ground pad is electrically connected to the ground layer using a coin arranged in the first printed circuit board or using a plurality of vias extending through the first printed circuit board. This coin is typically made from copper or another suitable thermal and electrical conductor. Furthermore, the second printed circuit board may comprise a first side and a second side opposite to the first side, wherein the second printed circuit board comprises a die pad and a plurality of bondpads arranged on the first side of the second printed circuit board, and a module ground pad arranged on the second side of the second printed circuit board, wherein the first and second module input/output pad are arranged on the second side of the second printed circuit board, wherein the module ground pad is electrically connected to the die pad using a coin arranged in the second printed circuit board or using a plurality of vias extending through the second printed circuit board. Also this coin is typically made from copper or another suitable thermal and electrical conductor. It should be noted that the second printed circuit board may comprise many more module input/output pads arranged on the second side of the second printed circuit board, and that the first printed circuit board may comprise corresponding board input/output pads. Furthermore, the semiconductor die may have a first side and a second side opposite to the first side, wherein the semiconductor die can be provided with a backside metallization arranged on the second side of the semiconductor die. The backside metallization can be fixedly connected to the die pad in a conductive manner. In addition, the power transistor may further comprise a second output, wherein the semiconductor die comprises a plurality of vias or a conductive substrate for electrically connecting the second output to the backside metallization. The first output or input may be connected using a bondwire to a first bondpad among the plurality of bondpads, and the first module input/output pad can be electrically connected to the first bondpad. The decoupling capacitor can be arranged on the first side of the second printed circuit board.

The first module input/output pad can be fixedly connected to a first board input/output pad arranged on the first printed circuit board. Similarly, the second module input/output pad can be fixedly connected to a second board input/output pad on the first printed circuit board. This second board input/output pad can be physically and electrically connected using a metal trace and/or via to the board ground pad, or it is physically and electrically connected using a metal trace and/or via to the ground layer.

The power amplifier module may comprise a solidified molding compound encapsulating the semiconductor die. This molding compound partially defines and forms the outer shape of the power amplifier module.

The at least one power transistor may comprise a field-effect transistor, wherein the input comprises a gate of the field-effect transistor, the first output a drain of the field-effect transistor, and the second output a source of the field-effect transistor. For example, the field-effect transistor may comprise a silicon based laterally diffused metal-oxide-semiconductor, LDMOS, transistor, or a gallium nitride based high electron mobility transistor, HEMT.

The power amplifier module may comprise a main amplifier and a peak amplifier forming a Doherty amplifier, wherein the at least one power transistor forms the main amplifier and/or the peak amplifier. The Doherty amplifier may comprise a Doherty splitter for splitting a signal to be amplified into a main part and a peak part, and for providing the main part to the main amplifier and the peak part to the peak amplifier. In addition, the Doherty amplifier may comprise a Doherty combiner for combining a signal amplified by the main amplifier and a signal amplified by the peak amplifier. The Doherty splitter and/or the Doherty combiner may be at least partially formed on the semiconductor die, and/or may be at least partially formed on the second printed circuit board.

The at least one power transistor is configured for outputting a power in a range between 1 and 110 Watt at an operational frequency lying in a range between 0.5 and 20 GHz, wherein the decoupling capacitor has a capacitance in a range between 0.001 and 10uF.

According to a second aspect, the present invention provides a power amplifier module to be used in a power amplifier as defined above, wherein the power amplifier module comprises a second printed circuit board having a first module input/output pad, a semiconductor die having at least one power transistor integrated thereon, wherein the semiconductor die is wire-bonded to the second printed circuit board, said power transistor comprising an input for receiving a signal to be amplified, and a first output for outputting the amplified signal, said first output or input being electrically connected to the first module input/output pad for receiving a biasing signal. The power amplifier module further comprises a decoupling capacitor mounted on the second printed circuit board and having a first terminal electrically coupled to the first module input/output pad.

The power amplifier module is characterized in that a second terminal of the decoupling capacitor is connected to a second module input/output pad of the power amplifier module that is electrically isolated from a module input/output pad of the power amplifier module, wherein the second module input/output pad is configured to be electrically grounded during operation.

The power amplifier module according to the second aspect of the present invention may be configured as the power amplifier module in the power amplifier according to the first aspect of the present invention.

Next, the present invention will be described in more detail referring to the appended drawings, wherein identical or similar components will be referred to using identical reference signs, and wherein:
Figures 1 - 3 illustrate a schematic top view, cross-sectional view, and electrical schematic of a known power amplifier, respectively, that includes a power amplifier module in accordance with the present invention;

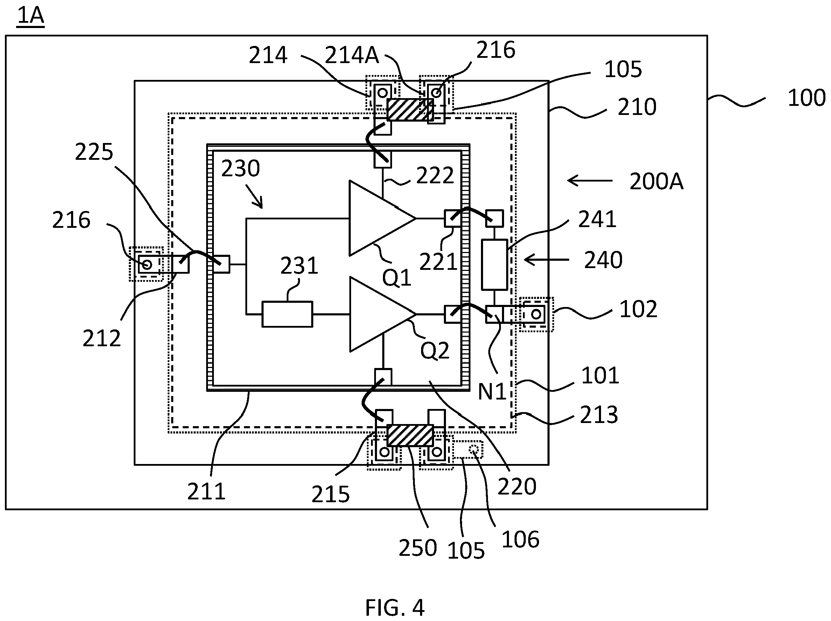

Figure 4 illustrates an embodiment of a power amplifier in accordance with the present invention; and

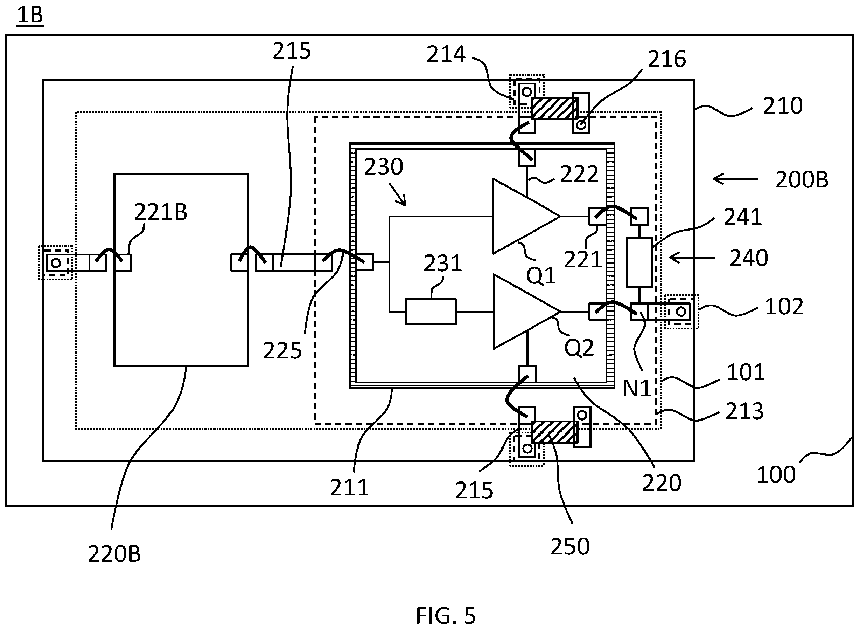

Figure 5 illustrates a further embodiment of a power amplifier in accordance with the present invention.

An embodiment of a power amplifier 1A in accordance with the present invention is shown in figure 4. Power amplifier 1A differs from power amplifier 1 shown in figure 1 in that the second terminal of SMD 250 is not connected to module ground pad 213 but to a separate module input/output pad 214A. Furthermore, figure 4 illustrates two different methods in which this can be achieved. For SMD 250 shown in the top of figure 4, the board input/output pad 102 that is connected to separate module input/output pad 214A is connected using a trace 105 to board ground pad 101, which latter pad is connected to ground layer 103.

For the SMD shown in the bottom of figure 4, the board input/output pad 102 that is connected to separate module input/output pad 214A is connected using a trace 105 and a via 106 that extends through first printed circuit board 100 to ground layer 103. The present invention is however not limited to the embodiments shown in figure 4. For example, first circuit board 100 may be a multi-layer board having one or more inner metal layers. The connection to ground layer 103 of the relevant board input/output pad 102 can also be via one or more of these inner metal layers.

The embodiment shown in figure 4 illustrates semiconductor die 200 on which a main and peak amplifier of a Doherty amplifier are realized. The present invention is not limited to such configuration and also covers embodiments in which a single or multi-stage amplifier is integrated on semiconductor die 200.

When testing power amplifier module 200A, module input/output 214A is left electrically floating. In this manner, no current will pass through SMD 250 and any possible leakage path through this component will not affect the leakage current tests of PAM 200A. However, when PAM 200A is mounted on first circuit board 100, module input/output pad 214A will be connected to ground layer 103, which is electrically grounded during operation. Hence, during operation, SMD 250 will provide suitable decoupling.

Figure 5 illustrates a further embodiment of a power amplifier 1B in accordance with the present invention. The figure 5 embodiment differs from the figure 4 embodiment in that a further semiconductor die 220B is mounted on second printed circuit board 200. On semiconductor die 220B other functionality can be implemented, such as baseband and/or control circuitry. Similar to semiconductor die 220, semiconductor die 220B is wire-bonded using bondpads 221B to second printed circuit board 210. However, the thermal requirements for semiconductor die 220B may be less stringent than those for semiconductor die 220. Consequently, other methods for connecting semiconductor die 220B to second printed circuit board 210 may be possible such as flip-chip.

Furthermore, although illustrated as also extending underneath semiconductor die 220B, module ground pad 213 may only extend underneath semiconductor die 220, as underneath semiconductor die 220 both a low thermal resistance and a low electrical resistance are important.

Module ground pad 213 and module input/output pads 214, 214A may be arranged to form a land grid array, LGA. However, the present invention could be extended to different packaging technologies as well in which PAM 200, 200A is mounted different to first printed circuit board 100, such as ball grid array technologies. In this latter case, module ground pad 213 could comprise a plurality of balls, such as solder balls or balls of a different material by which PAM 200, 200A can be mounted to first printed circuit board 100. Similarly, module input/output pads 214, 214A may each comprise one or more of such balls.

In the above, the present invention has been explained using detailed embodiments thereof. However, the present invention is not limited to these embodiments and various modifications are possible without departing from the scope of the present invention, which is defined by the appended claims and their equivalents.

For example, the embodiments shown in figures 4-5 are related to providing decoupling for the bias feed lines connected to the first outputs of power transistors Q1, Q2. However, the same decoupling could be used alternatively or additionally, for providing decoupling the bias feed lines connected to the inputs of power transistors Q1, Q2. In this case, the same or a different module input/output 214A can be used.

### REFERENCE SIGNS

- Power amplifier: 1, 1A, 1B
- First printed circuit board: 100
- Board ground pad: 101
- Board input/output pad: 102
- Ground layer: 103
- Copper coin: 104
- Trace: 105
- Via: 106
- Top side PCB: 110
- Power amplifier module: 200, 200A
- Second printed circuit board: 210
- Die pad: 211
- Bondpad: 212
- Module ground pad: 213
- Module input/output pad: 214, 214A
- Metal trace: 215
- Via: 216
- Copper coin: 217
- Semiconductor die: 220, 220B
- Die terminal: 221, 221B
- Bias feed line: 222
- Backside metallization: 223
- Bondwire: 225
- Doherty splitter: 230
- Phase shifter: 231
- Doherty combiner: 240
- Impedance inverter: 241
- Molding compound: 300
- Current: I
- Leakage current: I_{L}
- Combining node: N1
- Power transistor: Q1, Q2
- Time: t, t1
- Bias source: VI, V2

## Claims

1. A power amplifier, comprising:
a first printed circuit board comprising a ground layer configured to be electrically grounded during operation; and
a power amplifier module mounted on the first printed circuit board and comprising:
a second printed circuit board having a first module input/output pad;
a semiconductor die having at least one power transistor integrated thereon, wherein the semiconductor die is wire-bonded to the second printed circuit board, said at least one power transistor comprising an input for receiving a signal to be amplified, and a first output for outputting the amplified signal, said first output or said input being electrically connected to the first module input/output pad for receiving a biasing signal; and
a decoupling capacitor mounted on the second printed circuit board and having a first terminal electrically coupled to the first module input/output pad;
**characterized in that** a second terminal of the decoupling capacitor is connected to a second module input/output pad of the power amplifier module that is electrically isolated from the first module input/output pad of the power amplifier module, said second module input/output pad being electrically connected to the ground layer.

2. The power amplifier according to claim 1, wherein the first printed circuit board comprises a first side and a second side opposite to the first side, said first printed circuit board comprising a board ground pad and a plurality of board input/output pads arranged on the first side, wherein the board ground pad is electrically connected to the ground layer using a coin arranged in the first printed circuit board or using a plurality of vias extending through the first printed circuit board.

3. The power amplifier according to claim 2, wherein the second printed circuit board comprises a first side and a second side opposite to the first side, wherein the second printed circuit board comprises a die pad and a plurality of bondpads arranged on the first side of the second printed circuit board, and a module ground pad arranged on the second side of the second printed circuit board, wherein the first and second module input/output pad are arranged on the second side of the second printed circuit board, wherein the module ground pad is electrically connected to the die pad using a coin arranged in the second printed circuit board or using a plurality of vias extending through the second printed circuit board.

4. The power amplifier according to claim 3, wherein the semiconductor die has a first side and a second side opposite to the first side, wherein the semiconductor die is provided with a backside metallization arranged on the second side of the semiconductor die, wherein the backside metallization is fixedly connected to the die pad in a conductive manner, wherein the power transistor further comprises a second output, wherein the semiconductor die comprises a plurality of vias or a conductive substrate for electrically connecting the second output to the backside metallization, and wherein the first output or the input is connected using a bondwire to a first bondpad among the plurality of bondpads, wherein the first module input/output pad is electrically connected to the first bondpad.

5. The power amplifier according to claim 3 or 4, wherein the decoupling capacitor is arranged on the first side of the second printed circuit board.

6. The power amplifier according to any of the claims 2-5, wherein the first module input/output pad is fixedly connected to a first board input/output pad arranged on the first printed circuit board, and wherein the second module input/output pad is fixedly connected to a second board input/output pad on the first printed circuit board.

7. The power amplifier according to claim 6, wherein the second board input/output pad is physically and electrically connected using a metal trace and/or via to the board ground pad.

8. The power amplifier according to claim 6, wherein the second board input/output pad is physically and electrically connected using a metal trace and/or via to the ground layer.

9. The power amplifier according to any of the previous claims, wherein the power amplifier module comprises a solidified molding compound encapsulating the semiconductor die.

10. The power amplifier according to any of the previous claims, wherein the at least one power transistor comprises a field-effect transistor, wherein the input comprises a gate of the field-effect transistor, the first output a drain of the field-effect transistor, and, in so far as depending on 4, a second output a source of the field-effect transistor.

11. The power amplifier according to claim 10, wherein the field-effect transistor comprises a silicon based laterally diffused metal-oxide-semiconductor, LDMOS, transistor, or a gallium nitride based high electron mobility transistor, HEMT.

12. The power amplifier according to any of the previous claims, wherein the power amplifier module comprises a main amplifier and a peak amplifier forming a Doherty amplifier, wherein the at least one power transistor forms the main amplifier and/or the peak amplifier.

13. The power amplifier according to claim 12, wherein the Doherty amplifier comprises:
a Doherty splitter for splitting a signal to be amplified into a main part and a peak part, and for providing the main part to the main amplifier and the peak part to the peak amplifier; and
a Doherty combiner for combining a signal amplified by the main amplifier and a signal amplified by the peak amplifier;
wherein the Doherty splitter and/or the Doherty combiner are at least partially formed on the semiconductor die, and/or at least partially formed on the second printed circuit board.

14. The power amplifier according to any of the previous claims, wherein the at least one power transistor is configured for outputting a power in a range between 1 and 110 Watt and at an operational frequency lying in a range between 0.5 and 20 GHz, wherein the decoupling capacitor has a capacitance in a range between 0.001 and 10 uF.

15. A power amplifier module to be used in a power amplifier as defined in any of the previous claims, wherein the power amplifier module comprises:
a second printed circuit board having a first module input/output pad;
a semiconductor die having at least one power transistor integrated thereon, wherein the semiconductor die is wire-bonded to the second printed circuit board, said at least one power transistor comprising an input for receiving a signal to be amplified, and a first output for outputting the amplified signal, said first output or said input being electrically connected to the first module input/output pad for receiving a biasing signal; and
a decoupling capacitor mounted on the second printed circuit board and having a first terminal electrically coupled to the first module input/output pad;
**characterized in that** a second terminal of the decoupling capacitor is connected to a second module input/output pad of the power amplifier module that is electrically isolated from the first module input/output pad of the power amplifier module, said second module input/output pad being electrically connected to a ground layer of the first circuit board of the power amplifier when the power amplifier module is mounted on the first circuit board of the power amplifier.
